(19) **Europäisches Patentamt** / **European Patent Office** / **Office européen des brevets**

(11) **EP 3 798 643 B1**

(12) # EUROPEAN PATENT SPECIFICATION

(45) Date of publication and mention
of the grant of the patent:
**01.05.2024 Bulletin 2024/18**

(21) Application number: **19382824.1**

(22) Date of filing: **25.09.2019**

(51) International Patent Classification (IPC):
**G01R 15/24** (2006.01)   **G01R 19/00** (2006.01)
**G01R 33/032** (2006.01)

(52) Cooperative Patent Classification (CPC):
**G01R 19/0092; G01R 15/246; G01R 15/247;
G01R 33/0322**

(54) **OPTICAL FIBER-BASED CURRENT MEASURING EQUIPMENT FOR MEASURING THE CURRENT CIRCULATING THROUGH A CONDUCTOR AND ASSOCIATED METHOD**

GLASFASERBASIERTE STROMMESSVORRICHTUNG ZUR MESSUNG DES DURCH EINEN LEITER ZIRKULIERENDEN STROMS UND ZUGEHÖRIGES VERFAHREN

ÉQUIPEMENT DE MESURE DE COURANT À FIBRE OPTIQUE POUR MESURER LE COURANT CIRCULANT DANS UN CONDUCTEUR ET PROCÉDÉ ASSOCIÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**31.03.2021 Bulletin 2021/13**

(73) Proprietor: **Lumiker Aplicaciones Tecnologicas
S.L.
48160 Derio (ES)**

(72) Inventor: **BENGOECHEA DE LA LLERA, Francisco
Javier
48180 Loiu (ES)**

(74) Representative: **Igartua, Ismael
Galbaian S. Coop.
Garaia Parke Teknologikoa
Goiru Kalea 1
20500 Arrasate-Mondragón (ES)**

(56) References cited:
EP-A1- 3 598 149     EP-A2- 0 729 033
WO-A1-2016/198575    CN-A- 106 645 911
CN-B- 102 539 873    CN-U- 203 011 982
DE-C1- 4 227 903     JP-A- H01 292 263
JP-A- S57 184 975    US-A- 5 963 026
US-A1- 2007 065 156  US-A1- 2011 051 145
US-A1- 2012 121 216  US-B1- 6 297 625
US-B1- 6 301 400     US-B1- 6 438 234

US-B1- 6 515 467

- LIN H ET AL: "FIBER-OPTIC CURRENT SENSOR USING PASSIVE DEMODULATION INTERFEROMETRIC SCHEME", FIBER AND INTEGRATED OPTICS, TAYLOR & FRANCIS, LONDON, GB, vol. 18, no. 2, 1 January 1999 (1999-01-01), pages 79-92, XP000905966, ISSN: 0146-8030, DOI: 10.1080/014680399244721
- NING Y N ET AL: "RECENT PROGRESS IN OPTICAL CURRENT SENSING TECHNIQUES", REVIEW OF SCIENTIFIC INSTRUMENTS, AIP, MELVILLE, NY, US, vol. 66, no. 5, 1 May 1995 (1995-05-01), pages 3097-3111, XP000507794, ISSN: 0034-6748, DOI: 10.1063/1.1145537
- SHAYNE X SHORT ET AL: "Elimination of Birefringence Induced Scale Factor Errors in the In-Line Sagnac Interferometer Current Sensor", JOURNAL OF LIGHTWAVE TECHNOLOGY, IEEE, USA, vol. 16, no. 10, 1 October 1998 (1998-10-01), XP011029247, ISSN: 0733-8724
- MYUNG LAE LEE ET AL: "A polarimetric current sensor using an orthogonally polarized dual-frequency fibre laser", MEASUREMENT SCIENCE AND TECHNOLOGY, IOP, BRISTOL, GB, vol. 9, no. 6, 1 June 1998 (1998-06-01), pages 952-959, XP020064511, ISSN: 0957-0233, DOI: 10.1088/0957-0233/9/6/012

EP 3 798 643 B1

- **BUSH S P ET AL: "DUAL-CHANNEL FARADAY-EFFECT CURRENT SENSOR CAPABLE OF SIMULTANEOUS MEASUREMENT OF TWO INDEPENDENT CURRENTS", OPTICS LETTERS, OPTICAL SOCIETY OF AMERICA, US, vol. 16, no. 12, 15 June 1991 (1991-06-15) , pages 955-957, XP000216275, ISSN: 0146-9592**
- **HUI CAO ET AL: "A Novel Design of Fiber-Optic Sagnac Current Sensor", COMPUTATIONAL INTELLIGENCE AND DESIGN (ISCID), 2012 FIFTH INTERNATIONAL SYMPOSIUM ON, IEEE, 28 October 2012 (2012-10-28), pages 89-92, XP032302266, DOI: 10.1109/ISCID.2012.174 ISBN: 978-1-4673-2646-9**
- **WANG Z P ET AL: "Recent advances in optical current-sensing techniques", SENSORS AND ACTUATORS A: PHYSICAL, ELSEVIER BV, NL, vol. 50, no. 3, 1 September 1995 (1995-09-01), pages 169-175, XP027208108, ISSN: 0924-4247 [retrieved on 1995-09-01]**

**Description**

TECHNICAL FIELD

The present invention relates to optical fiber-based current measuring equipment for measuring the current circulating through a conductor, and to a method for measuring the current circulating through a conductor with optical fiber-based current measuring equipment.

PRIOR ART

Optical fiber-based sensors for measuring the current circulating through a conductor are known. Said sensors work according to the Faraday effect, i.e., the magnetic field generated by the current circulating through the conductor causes a rotation in the polarization of light circulating through the optical fiber arranged around the conductor. The operation of optical fiber-based measuring equipment consists of emitting light through an optical fiber towards a sensing portion in which the characteristics of the light are modified depending on the current circulating through the conductor, and analyzing the rotation caused in the polarization of light to determine the magnitude of the current passing through the conductor.

WO2016198575A1, belonging to the same applicant, describes optical fiber-based current measuring equipment and an associated method. The current measuring equipment comprises an interrogator with an emitter and a receiver, and a sensing portion close to the conductor. The interrogator and the sensing portion are suitable for being connected through a standard single-mode intermediate fiber. The patent document describes several ways for implementing both the interrogator and the sensing portion. In one of the embodiments, the sensing portion comprises a first branch comprising a first polarizer and a fiber twist after said first polarizer, a second branch comprising a second polarizer, and a sensing branch comprising a sensing section arranged in the proximity of the conductor and a mirror. The first branch and the second branch are coupled to the sensing branch by means of a splitter.

In the method described for this embodiment, the pulses emitted by the emitter are received in the sensing branch through the first branch, whereas the pulses modified depending on the current circulating through the conductor are received by the receiver from the second branch.

Documents JPH01292263A, DE4227903C1, US2011/0051145A1 and US6297625B1 also disclose optical fiber-based sensors.

DISCLOSURE OF THE INVENTION

The object of the invention is to provide optical fiber-based current measuring equipment for measuring the current circulating through at least one conductor, and a method for measuring the current circulating through at least one conductor with optical fiber-based measuring equipment, as defined in the claims.

A first aspect of the invention relates to optical fiber-based measuring equipment for measuring the current circulating through at least one conductor, according to claim 3.

The measuring equipment comprises an interrogator comprising a first emitter, a second emitter, a first receiver, and a second receiver.

The measuring equipment also comprises a sensing portion connected to the interrogator and configured for being arranged in the proximity of the conductor.

The sensing portion comprises a first input branch comprising a first polarizer and a fiber twist after said first polarizer, and a second input branch comprising a second polarizer.

The sensing portion also comprises a first sensing branch comprising a first optical fiber winding arranged in the proximity of the conductor and a first Faraday mirror, and a second sensing branch comprising a second optical fiber winding arranged in the proximity of the conductor, a second Faraday mirror, and a delaying element between the second optical fiber winding and the second Faraday mirror.

The first input branch and the second input branch are coupled to the first sensing branch and to the second sensing branch by means of a splitter.

The measuring equipment is configured to carry out the method according to a second aspect of the invention described below.

The second aspect of the invention relates to a method for measuring the current circulating through a conductor according to claim 1 with current measuring equipment like the one described above

In the method of the invention, the first emitter emits a first signal which reaches the first sensing branch through the first input branch, travels along the first sensing branch and is modified depending on the current circulating through the conductor, and is received by the second receiver from the second input branch.

The second emitter emits a second signal which reaches the first sensing branch through the second input branch, travels along the first sensing branch and is modified depending on the current circulating through the conductor, and is received by the first receiver from the first input branch.

The first signal also reaches the second sensing branch through the first input branch, and the second signal also reaches the second sensing branch through the second input branch. The first signal and the second signal travel along said second sensing branch and are modified depending on the current circulating through the conductor.

The second receiver receives from the second input branch the first signal modified in the second sensing branch, the first receiver also receiving from the first input branch the second signal modified in the second sensing branch.

The current circulating through the conductor is determined by combining the first signal modified in the first sensing branch and received by the second receiver, the second signal modified in the first sensing branch and received by the first receiver, the first signal modified in the second sensing branch and received by the second receiver, and the second signal modified in the second sensing branch and received by the first receiver.

By means of these four cross signals, a precise calculation of the current circulating through the conductor is obtained, with a high dynamic range. As the two optical fiber windings have the same length but are arranged opposite one another, they exhibit the same response in the deviation of light polarization, but in phase opposition, i.e., with a 180-degree offset. This configuration allows determining the current circulating through the conductor in a very precise manner, particularly in values in which the current circulating through the conductor is low, and therefore the signal/noise ratio is high, given that this configuration allows for good noise cancelation without having to use filters to eliminate said noise. Likewise, obtaining very good noise elimination offers very good measurements of the conductors through which direct current circulates and in which filters cannot be used. Furthermore, by processing the signals obtained in the first receiver and in the second receiver, it is possible to obtain a precise calculation of the attenuations caused by the different connection fibers of the measuring equipment.

These and other advantages and features of the invention will become evident in view of the drawings and the detailed description of the invention.

## DESCRIPTION OF THE DRAWINGS

Figure 1 schematically shows optical fiber-based current measuring equipment according to a first embodiment of the invention.

Figure 2 schematically shows optical fiber-based current measuring equipment according to a second embodiment of the invention.

## DETAILED DISCLOSURE OF THE INVENTION

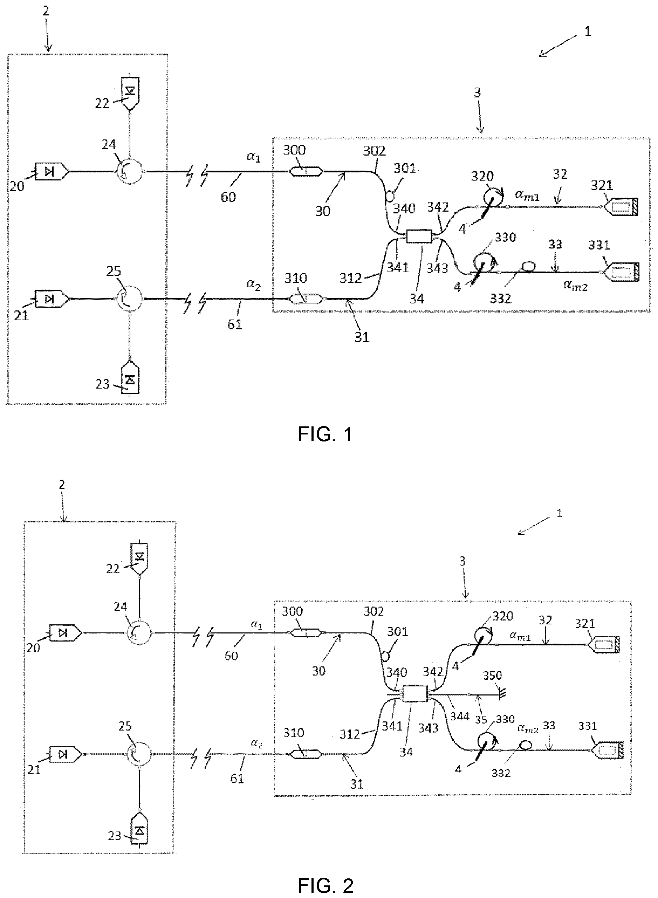

Figure 1 shows a first embodiment of the optical fiber-based current measuring equipment 1 for measuring the current circulating through a conductor 4.

The measuring equipment 1 comprises an interrogator 2 comprising a first emitter 20 and a second emitter 21. The interrogator 2 also comprises a first receiver 22 and a second receiver 23.

Furthermore, the measuring equipment 1 comprises a sensing portion 3 connected to the interrogator 2 and configured for being arranged in the proximity of the conductor 4.

The sensing portion 3 comprises a first input branch 30 comprising a first polarizer 300 and a fiber twist 301 after said first polarizer 300. Preferably, the first polarizer 300 is a linear polarizer filtering the input signal allowing only a specific oscillation direction of the electric field of the light to go through. Preferably, the first polarizer 300 only allows the part of the signal oscillating at 0 degrees to go through. Preferably, the fiber twist 301 is a geometric rotator which is obtained by means of twisting the fiber 302 connecting the first polarizer 300 to the splitter 34.

The sensing portion 3 also comprises a second input branch 31 comprising a second polarizer 310. Preferably, said second polarizer 310 is a linear polarizer filtering the input signal allowing only a specific oscillation direction of the electric field of the light to go through. Preferably, the second polarizer 310 only allows the part of the signal oscillating at 0 degrees to go through.

The sensing portion 3 also comprises a first sensing branch 32 comprising a first optical fiber winding 320 arranged in the proximity of the conductor 4 and a first Faraday mirror 321.

Furthermore, the sensing portion 3 comprises a second sensing branch 33 comprising a second optical fiber winding 330 arranged in the proximity of the conductor 4, a second Faraday mirror 331, and a delaying element 332 between the second optical fiber winding 330 and the second Faraday mirror 331. The delaying element 332 of the second sensing branch 33 is necessary so that the first receiver 22 and the second receiver 23 can differentiate the signal received from the first sensing branch 32 from the signal received from the second sensing branch 33, i.e., it allows managing the signals received in the receivers 22 and 23 of the interrogator 2. Preferably, the delaying element 332 consists of arranging a length of additional fiber between the second optical fiber winding 330 and the second Faraday mirror 331, such that the signals circulating through said second sensing branch 33 travel along a distance greater than the distances they travel along the first sensing branch 32, the signals travelling along the second sensing branch 33 reaching the receivers 22 and 23 of the interrogator 2 with an offset with respect to the signals travelling along the first sensing branch 32. Since the mirrors 321 and 331 used for reflecting the signals of the sensing branches 32 and 33 are Faraday-type mirrors, the delaying element 332 by way of an additional fiber arranged between the second optical fiber winding 330 and the Faraday mirror 331 does not affect the measurement of the current circulating through the conductor 4. Furthermore, using Faraday mirrors causes the response of the first optical fiber winding 320 and of the second optical fiber winding 330 to stabilize, improving calculation of the current of the conductor 4.

The sensing portion 3 also comprises a splitter 34 coupling the first input branch 30 and the second input branch 31 to the first sensing branch 32 and to the second sensing branch 33.

As observed in Figure 1, the splitter 34 of the first embodiment is a splitter 34 comprising two inputs 340 and 341 and two outputs 342 and 343. In this first embodiment, the first input branch 30 of the sensing portion 3 is connected to the first input 340 of the splitter 34, the second input branch 31 is connected to the second input 341 of the splitter 34, the first sensing branch 32 is connected to the first output 342 of the splitter 34, and the second sensing branch 33 is connected to the second output 343 of the splitter 34. When a first signal emitted by the first emitter 20 reaches the first input 340 of the splitter 34, the splitter 34 splits the power of said first signal in two, with the first signal exiting through each of the outputs 342 and 343 of the splitter 34, but with half the power. Similarly, when a second signal emitted by the second emitter 21 reaches the second input 341 of the splitter 34, the splitter 34 splits the power of said second signal in two, with the second signal exiting through each of the outputs 342 and 343 of the splitter 34, but with half the power. When a signal circulates in the opposite direction, i.e., when the first signal or the second signal modified in the first sensing branch 32 reaches the first output 342 of the splitter 34, the operation of said splitter 34 is the same, splitting the power of said modified signal in two, with the modified signal exiting through each of the inputs 340 and 341 of the splitter 34, but with half the power. Similarly, when the first signal or the second signal modified in the second sensing branch 33 reaches the second output 343 of the splitter 34, the splitter 34 splits the power of said modified signal in two, with the modified signal exiting through each of the inputs 340 and 341 of the splitter 34, but with half the power.

The first optical fiber winding 320 of the first sensing branch 32 and the second optical fiber winding 330 of the second sensing branch 33 comprise the same number of turns that are, however, wound in opposite directions. In other words, one of the optical fiber windings will be wound clockwise, whereas the other optical fiber winding will be wound anticlockwise, obtaining a sensing portion comprising two optical fiber windings of the same length but arranged opposite one another. Since the first optical fiber winding 320 and the second optical fiber winding 330 have the same length, they exhibit the same response in the deviation of light polarization, but since the windings are arranged in opposite directions, said responses are in phase opposition, i.e., they are offset by 180 degrees.

This configuration allows determining the current circulating through the conductor 4 in a very precise manner, particularly at values in which the current circulating through the conductor 4 is low and therefore the signal/noise ratio is high, given that this configuration allows for good noise cancelation without having to use filters to eliminate said noise. Likewise, obtaining good noise elimination offers very good measurements of the conductors 4 through which direct current circulates and in which filters cannot be used. Furthermore, by processing the signals obtained in the first receiver 22 and in the second receiver 23, it is possible to obtain a precise calculation of the fiber twist 301 of the first input branch 30 and of the attenuations $\alpha_1$, $\alpha_2$, $\alpha_{m1}$, and $\alpha_{m2}$ caused by the different connection fibers of the measuring equipment 1.

In this first embodiment, the interrogator 2 comprises a first circulator 24 connecting the first emitter 20 and the first receiver 22 of the interrogator 2 to the first input branch 30 of the sensing portion 3. Furthermore, in this first embodiment the first circulator 24 and the first input branch 30 of the sensing portion 3 are connected through a first intermediate fiber 60, as observed in Figure 1. The first circulator 24 therefore couples the signal emitted by the first emitter 20 to the first input branch 30 of the sensing portion 3 through the first intermediate fiber 60. The first circulator 24 also couples the signal modified in the sensing portion 3 to the first receiver 22 through the first intermediate fiber 60.

Similarly, in this first embodiment the interrogator 2 comprises a second circulator 25 connecting the second emitter 21 and the second receiver 23 of the interrogator 2 to the second input branch 31 of the sensing portion 3. Furthermore, in this first embodiment the second circulator 25 and the second input branch 31 of the sensing portion 3 are connected through a second intermediate fiber 61, as observed in Figure 1. The second circulator 25 therefore couples the signal emitted by the second emitter 21 to the second input branch 31 of the sensing portion 3 through the second intermediate fiber 61. The second circulator 25 also couples the signal modified in the sensing portion 3 to the second receiver 23 through the second intermediate fiber 61.

Preferably, the first intermediate fiber 60 and the second intermediate fiber 61 are standard single-mode (SM) fibers. To enable joining the interrogator 2 with the sensing portion 3 through standard single-mode type intermediate fibers 60 and 61, the concept described in patent document WO2016198575A1, belonging to the same applicant, is used. Therefore, preferably both the signal emitted by the first emitter 20 and the signal emitted by the second emitter 21 is a signal made up of a set of at least two polarized light pulses, said polarized pulses having a specific difference in degrees, said difference in polarization preferably being 90 degrees. In other words, preferably the first emitter 20 and the second emitter 21 of the interrogator 2 are configured for emitting signals comprising a set of at least two polarized light pulses, said polarized pulses having a specific difference in degrees. To that end, the first emitter 20 and the second emitter 21 of the interrogator 2 can be of any type described in patent document WO2016198575A1 or of any other type known to the person skilled in the art and complying with the requirements described above.

As described in patent document WO2016198575A1, if standard single-mode fibers 60 and 61 are used for joining the interrogator 2 with the sensing portion 3, these fibers can vary the characteristics of the light signal emitted from the emitter, for example in the polarization thereof. Said intermediate fibers can modify light polarization due to different aspects, such as the temperature of said fibers, the vibrations they undergo, etc. The emission of signals made up of sets of at least two polarized light pulses, said polarized pulses having a specific difference in degrees, means that the measuring equipment can compensate for alterations in polarization caused by the intermediate fibers. The polarized light pulses of the set of pulses can be simultaneous or can be emitted within a small time interval between said pulses, given that it is thereby assured that the behavior of the intermediate fiber is the same for all the pulses of the set of pulses. Therefore, as explained in patent document WO2016198575A1, since the characteristics of the intermediate fiber do not affect current measurement, an intermediate fiber of the required length can be used. It is therefore possible to arrange the sensing portion 3 and the interrogator 2 at a distance of several kilometers without the measurement being affected by said intermediate fibers 60 and 61. The current of conductors located in remote sites can therefore be measured without having to arrange the interrogator 2 in said locations which may not comply with the requirements necessary for the operation of said interrogators, for example, or may not have a reliable power supply.

As mentioned above, the first input branch 30 of the sensing portion 3 comprises a fiber twist 301. Ideally, said fiber twist 301 is about 45 degrees. As described in European patent application EP18196585.6, belonging to the same applicant, with a 45-degree rotation the quadratic terms of the signals used for calculating the current circulating through the conductor 4 are cancelled. Therefore, the sensitivity of the measuring equipment 1 is maximized, in addition to providing phase information.

In this first embodiment, the fiber 312 connecting the second polarizer 310 to the splitter 34 does not provide any rotation to the signal going through same. In other possible embodiments not shown in the drawings, the second input branch may comprise an additional fiber twist after the second polarizer, the sum of the fiber twist of the first input branch and the additional fiber twist of the second input branch preferably being about 45 degrees.

In the method of the invention applied to this first embodiment, the first emitter 20 emits a first signal which reaches the first sensing branch 32 through the first input branch 30, travels along said first sensing branch 32 and is modified depending on the current circulating through the conductor 4, and is received by the second receiver 23 from the second input branch 31. Furthermore, the second emitter 21 emits a second signal which reaches the first sensing branch 32 through the second input branch 31, travels along the first sensing branch 32 and is modified depending on the current circulating through the conductor 4, and is received by the first receiver 22 from the first input branch 30.

Moreover, said first signal emitted by the first emitter 20 also reaches the second sensing branch 33 through the first input branch 30, and said second signal emitted by the second emitter 21 also reaches the second sensing branch 33 through the second input branch 31. The first signal and the second signal travel along said second sensing branch 33 and are modified depending on the current circulating through the conductor 4. The second receiver 23 receives from the second input branch 31 the first signal modified in the second sensing branch 33, whereas the first receiver 22 receives from the first input branch 30 the second signal modified in the second sensing branch 33.

Therefore, the current circulating through the conductor 4 is determined by combining the first signal modified in the first sensing branch 32 and received by the second receiver 23, the second signal modified in the first sensing branch 32 and received by the first receiver 22, the first signal modified in the second sensing branch 33 and received by the second receiver 23, and the second signal modified in the second sensing branch 33 and received by the first receiver 22.

In the context of the invention, self signal will be considered that signal which is emitted by the first emitter 20 and received by the first receiver 22 after being reflected in the sensing portion 3, and that signal which is emitted by the second emitter 21 and received by the second receiver 23 after being reflected in the sensing portion 3. In contrast, cross signal will be considered that signal which is emitted by the first emitter 20 and received by the second receiver 23 after being reflected in the sensing portion 3, and that signal which is emitted by the second emitter 21 and received by the first receiver 22 after being reflected in the sensing portion 3.

Therefore, cross signals are used for determining the current circulating through the conductor 4, whereas self signals, which will also reach the first receiver 22 and the second receiver 23, are rejected.

In this first embodiment, the first receiver 22 and the second receiver 23 comprise a respective photodiode. As mentioned above, the first receiver 22 will receive the second signal modified in the first sensing branch 32 and in the second sensing branch 33, whereas the second receiver 23 will receive the first signal modified in the first sensing branch 32 and in the second sensing branch 33. The photodiodes convert light into intensity, such that the control unit, not shown in the drawings, can determine the current circulating through the conductor 4 by processing and combining the intensity it receives from the photodiode of the first receiver 22 and the intensity it receives from the photodiode of the second receiver 23.

On one hand, there are the two cross signals which have been modified in the first optical fiber winding 320 of the first sensing branch 32:

$$R_{12} = \alpha_{m1}P_{12}[cos^2(2\gamma\varphi)sin^2\theta_d + \gamma^2 sin^2(2\gamma\varphi)cos^2\theta_d - 2\gamma\sin(2\gamma\varphi)\cos(2\gamma\varphi)cos\theta_d\sin\theta_d]$$

$$R_{21} = \alpha_{m1}P_{21}[cos^2(2\gamma\varphi)sin^2\theta_d + \gamma^2 sin^2(2\gamma\varphi)cos^2\theta_d + 2\gamma\sin(2\gamma\varphi)\cos(2\gamma\varphi)cos\theta_d\sin\theta_d]$$

On the other hand, there are the two cross signals which have been modified in the second optical fiber winding 330 of the second sensing branch 33:

$$Q_{12} = \alpha_{m2}P_{12}[cos^2(2\gamma\varphi)sin^2\theta_d + \gamma^2 sin^2(2\gamma\varphi)cos^2\theta_d + 2\gamma\sin(2\gamma\varphi)\cos(2\gamma\varphi)cos\theta_d\sin\theta_d]$$

$$Q_{21} = \alpha_{m2}P_{21}[cos^2(2\gamma\varphi)sin^2\theta_d + \gamma^2 sin^2(2\gamma\varphi)cos^2\theta_d - 2\gamma\sin(2\gamma\varphi)\cos(2\gamma\varphi)cos\theta_d\sin\theta_d]$$

Where

$R_{12}$= The light intensity measured by the second receiver 23 relative to the first signal modified in the first sensing branch 32.
$R_{21}$= The light intensity measured by the first receiver 22 relative to the second signal modified in the first sensing branch 32.
$Q_{12}$= The light intensity measured by the second receiver 23 relative to the first signal modified in the second sensing branch 33.
$Q_{21}$= The light intensity measured by the first receiver 22 relative to the second signal modified in the second sensing branch 33.
$\alpha_{m1}$= The attenuation of the first sensing branch 32.
$\alpha_{m2}$= The attenuation of the second sensing branch 33.

$$P_{12} = P_1\alpha_1\alpha_2R_2$$

Where:

$P_1$= Power of the light emitted by the first emitter 20
$\alpha_1$= Attenuation of fibers 60 and 302
$\alpha_2$= Attenuation of fibers 312 and 61
$R_2$= Receiving gain of the second receiver 23.

$$P_{21} = P_2\alpha_2\alpha_1R_1$$

Where:

$P_2$= Power of the light emitted by the second emitter 21 $\alpha_1$= Attenuation of fibers 60 and 302
$\alpha_2$= Attenuation of fibers 312 and 61
$R_1$= Receiving gain of the first receiver 22.

$$\gamma = \frac{\left(\frac{\delta_c}{2} + \psi\right)}{\sqrt{\left(\frac{\delta_l}{2}\right)^2 + \left(\frac{\delta_c}{2} + \psi\right)^2}}$$

Where:

$\delta_c$= circular birefringence of the fiber of optical fiber winding 320 and 330
$\psi$= rotation of the fiber of optical fiber winding 320 and 330
$\delta_l$= linear birefringence of the fiber of optical fiber winding 320 and 330

Since $\delta_l < \left(\frac{\delta_c}{2} + \psi\right)$ is always true, it means that y is approximately 1 in all cases.

$$\varphi = V * B * l$$

Where:

V= Verdet constant of the optical fiber at the working wavelength
B= the magnetic field generated by the conductor 4.
l= the length of optical fiber winding 320 and 330.
$\Theta_d$ = The rotation provided by fiber twist 301 of the first input branch 30.

The following relations can be obtained by performing subtraction, addition, and square root operations on these equations:

$$\left[\sqrt{R_{21}} - \sqrt{Q_{21}}\right] + \left[\sqrt{Q_{12}} - \sqrt{R_{12}}\right] = \sqrt{(\alpha_{m1} + \alpha_{m2})(P_{21} + P_{12})}\sin(2\varphi)cos\theta_d +$$
$$\sqrt{(\alpha_{m1} - \alpha_{m2})(P_{21} - P_{12})}\cos(2\varphi)\,sen\theta_d$$

$$\left[\sqrt{R_{21}} - \sqrt{R_{12}}\right] + \left[\sqrt{Q_{12}} - \sqrt{Q_{21}}\right] = \sqrt{(\alpha_{m1} + \alpha_{m2})(P_{21} + P_{12})}\sin(2\varphi)cos\theta_d +$$
$$\sqrt{(\alpha_{m1} - \alpha_{m2})(P_{21} - P_{12})}\cos(2\varphi)\,sen\theta_d$$

Taking into account that:

$$\alpha_{m1} \approx \alpha_{m2} = \alpha_m$$

$$P_{12} \approx P_{21} = P$$

$$\gamma \approx 1$$

The error term has a double-zero coefficient $(\alpha_{m1} - \alpha_{m2})(P_{12} - P_{21})$. Therefore, if it is assumed that $(\alpha_{m1} - \alpha_{m2})(P_{12} - P_{21}) \approx 0$, the following final calculations for the signal are obtained:

$$sin(2\gamma\varphi) = \frac{\left[\sqrt{R_{21}} - \sqrt{Q_{21}}\right] + \left[\sqrt{Q_{12}} - \sqrt{R_{12}}\right]}{\sqrt{(\alpha_{m1} + \alpha_{m2})(P_{21} + P_{12})}cos\theta_d}$$

$$sin(2\gamma\varphi) = \frac{\left[\sqrt{R_{21}} - \sqrt{R_{12}}\right] + \left[\sqrt{Q_{12}} - \sqrt{Q_{21}}\right]}{\sqrt{(\alpha_{m1} + \alpha_{m2})(P_{21} + P_{12})}cos\theta_d}$$

Based on these formulas, value B relative to the magnetic field generated around the conductor 4 can be obtained, and therefore the intensity circulating through said conductor 4 can be determined in a very precise manner.
To enable performing said calculation, the $\alpha_m P$ value will be obtained from the following formulas:

$$2\alpha_m P = \frac{\left[\sqrt{R_{21}} + \sqrt{R_{12}}\right]^2}{sen^2\theta_d} + \frac{\left[\sqrt{R_{21}} - \sqrt{R_{12}}\right]^2}{cos^2\theta_d}$$

$$2\alpha_m P = \frac{\left[\sqrt{Q_{21}} + \sqrt{Q_{12}}\right]^2}{sen^2\theta_d} + \frac{\left[\sqrt{Q_{21}} - \sqrt{Q_{12}}\right]^2}{cos^2\theta_d}$$

$$2\alpha_m P = \frac{\left[\sqrt{R_{12}} + \sqrt{Q_{12}}\right]^2}{sen^2\theta_d} + \frac{\left[\sqrt{R_{12}} - \sqrt{Q_{12}}\right]^2}{cos^2\theta_d}$$

$$2\alpha_m P = \frac{\left[\sqrt{R_{21}} + \sqrt{Q_{21}}\right]^2}{sen^2\theta_d} + \frac{\left[\sqrt{R_{21}} - \sqrt{Q_{21}}\right]^2}{cos^2\theta_d}$$

As can be observed in the formulas which refer to the final calculation of the signal, the current measurement depends on the fiber twist 301. The value of the fiber twist 301 is defined in the manufacturing process, but it can undergo small variations during use of the measuring equipment 1. For this reason, if there is a need to perform a very precise calculation of the current of the conductor 4, it is advisable to gradually adapt the value of said fiber twist 301 to prevent error terms from being generated. Said value can also be calculated by means of the two cross signals which have been modified in the first optical fiber winding 320 of the first sensing branch 32.
As can be observed, quadratic terms are not seen in the equations obtained for the calculation of the current circulating through the conductor 4. This occurs as a result of the symmetrical double measurement performed, i.e., as a result of the combination of the cross signals. As described in European patent application EP18196585.6, belonging to the same applicant, with the symmetry of the cross signals of each sensing branch 32 and 33, the quadratic terms of the signal are eliminated, even in conditions in which the rotation provided to the signal by the fiber twist 301 is not 45 degrees, obtaining a resulting signal which maintains the shape of the signal and therefore allows obtaining the desired information. In the case of the present invention, since the first optical fiber winding 320 and the second optical fiber winding 330 have the same length, they exhibit the same response in the deviation of light polarization, but in phase opposition. Therefore, instead of having two cross signals to perform calculation of the current like in the case of document EP18196585.6, 4 cross signals are obtained, from which a more precise calculation of the current circulating through the conductor 4 can be obtained, given that the error term has a double-zero coefficient ($\alpha_{m1}$ - $\alpha_{m2}$)($P_{12}$- $P_{21}$). Furthermore, having these four cross signals allows performing a good assessment of the attenuations of the connection fibers and the attenuations of the sensing branches, and it also allows adjusting the fiber twist 301. A very precise current measurement with a high dynamic range is thus obtained.
As mentioned above, preferably both the signal emitted by the first emitter 20 and the signal emitted by the second emitter 21 is a signal made up of a set of at least two polarized light pulses, said polarized pulses having a specific difference in degrees, said difference in polarization preferably being 90 degrees. The emission of signals of this type allows compensating for possible changes in light polarization caused by the intermediate fibers 60 and 61 joining the interrogator 2 with the sensing portion 3.
Figure 2 shows a second embodiment of the measuring equipment 1.
The measuring equipment 1 of the second embodiment differs from the measuring equipment 1 of the first embodiment in that the sensing portion 3 also comprises an output branch 35. Said output branch 35 is coupled to the first input branch 30 and the second input branch 31 by means of the splitter 34. The rest of the configuration of the measuring equipment 1 is similar to that of the first embodiment so it is not considered necessary to describe it again.

The output branch 35 of this second embodiment is configured for returning the same signal it receives to the splitter 34. Therefore, signals from the first input branch 30 and the second input branch 31 reach the output branch 35 through the splitter 34, are reflected in the output branch 35, and return to the first input branch 30 and the second input branch 31 through the splitter 34. The signals reflected in the output branch 35 and received in the first receiver 22 and second receiver 23 allow adjusting some parameters required for performing a precise calculation of the current circulating through the conductor 4 in a more direct manner than by adjusting said values using only the cross signals of the first sensing branch 32 and the second sensing branch 33.

Therefore, the output branch 35 offers additional information for an even better adjustment of the different parameters when calculating the current circulating through the conductor 4, improving the dynamic range of the measuring equipment 1.

For the output branch 35 to reflect/return the same signal it receives, one of the options would simply be to make a "clean" cut on the actual corresponding output terminal 344 of the splitter, such that said cut would cause the signal to rebound in the output terminal 343 due to the sudden change in the refractive index which said cut would cause. Another option would be to place a conventional mirror 350, as shown in Figure 2. In other possible embodiments, the signal can be returned in any other way known to the person skilled in the art, provided that the signal returned by the output branch is the same as the one received by said output branch.

In the embodiments in which the measuring equipment comprises an output branch in addition to the two sensing branches, it may be necessary for the first sensing branch to comprise a delaying element between the first optical fiber winding and the first Faraday mirror, the delaying element of first the sensing branch and the delaying element of the second sensing branch being different from one another to enable the receivers of the interrogator to manage the signals from the sensing branches and the output branch. In any case, the delaying element between the first optical fiber winding 320 and the first Faraday mirror 321 is dispensable if the fiber with which said first optical fiber winding 320 is made is long enough so as to delay the signals travelling along said first sensing branch 32 as much as possible so that the receivers 22 and 23 of the interrogator 2 can manage the signals from the two sensing branches 23 and 33 and the output branch 35, as shown in the embodiment of Figure 2.

In the method of the invention applied to this second embodiment, the first emitter 20 emits a first signal which reaches the first sensing branch 32 through the first input branch 30, travels along said first sensing branch 32 and is modified depending on the current circulating through the conductor 4, and is received by the second receiver 23 from the second input branch 31. Furthermore, the second emitter 21 emits a second signal which reaches the first sensing branch 32 through the second input branch 31, travels along the first sensing branch 32 and is modified depending on the current circulating through the conductor 4, and is received by the first receiver 22 from the first input branch 30.

Moreover, said first signal emitted by the first emitter 20 also reaches the second sensing branch 33 through the first input branch 30, and said second signal emitted by the second emitter 21 also reaches the second sensing branch 33 through the second input branch 31. The first signal and the second signal travel along said second sensing branch 33 and are modified depending on the current circulating through the conductor 4. The second receiver 23 receives from the second input branch 31 the first signal modified in the second sensing branch 33, whereas the first receiver 22 receives from the first input branch 30 the second signal modified in the second sensing branch 33.

Furthermore, the signal emitted by the first emitter 20 reaches the output branch 35 through the first input branch 30, is reflected in said output branch 35, and is received by the first receiver 22 from the first input branch 30 and by the second receiver 23 from the second input branch 31, and the signal emitted by the second emitter 21 reaches the output branch 35 through the second input branch 31, is reflected in said output branch 35, and is received by the first receiver 22 from the first input branch 30 and by the second receiver 23 from the second input branch 31.

Like in the method applied to the first embodiment, the current circulating through the conductor 4 is determined by combining the first signal modified in the first sensing branch 32 and received by the second receiver 23, the second signal modified in the first sensing branch 32 and received by the first receiver 22, the first signal modified in the second sensing branch 33 and received by the second receiver 23, and the second signal modified in the second sensing branch 33 and received by the first receiver 22.

This case involves the signals reflected in the output branch 35 in addition to the cross signals described in the first embodiment. In the case of the signals reflected in the output branch 35, both self signals and cross signals are used. These signals offer additional information for an even better adjustment of the different parameters while calculating the current, improving the dynamic range of the measuring equipment 1.

Specifically, these signals can be used for adjusting variations in the fiber twist 301 through the following formula:

$$\theta_d = \text{acos} \sqrt[4]{\frac{E_{12} * E_{21}}{E_{11} * E_{22}}}$$

Where

$E_{11}$= The light intensity measured by the first receiver 22 relative to the first signal reflected in the output branch 35.
$E_{12}$= The light intensity measured by the second receiver 23 relative to the first signal reflected in the output branch 35.
$E_{22}$= The light intensity measured by the second receiver 23 relative to the second signal reflected in the output branch 35.
$E_{21}$= The light intensity measured by the first receiver 22 relative to the second signal reflected in the output branch 35.

The signals reflected in the output branch 35 can also be used for determining the attenuations $\alpha_1$, $\alpha_2$, $\alpha_{m1}$, and $\alpha_{m2}$ caused by the different fibers of the measuring equipment 1.

**Claims**

1. Method for measuring the current circulating through at least one conductor (4) with optical fiber-based measuring equipment (1), the measuring equipment (1) comprising:

   - an interrogator (2) comprising a first emitter (20), a second emitter (21), a first receiver (22), and a second receiver (23), and
   - a sensing portion (3) connected to the interrogator (2) and configured for being arranged in the proximity of the conductor (4), the sensing portion (3) comprising:

     ◦ a first input branch (30) comprising a first polarizer (300) and a fiber twist (301) after said first polarizer (300),
     ◦ a second input branch (31) comprising a second polarizer (310),
     ◦ a first sensing branch (32) comprising a first optical fiber winding (320) configured for being arranged in the proximity of the conductor (4) and a first Faraday mirror (321), and
     ◦ a second sensing branch (33) comprising a second optical fiber winding (330) configured for being arranged in the proximity of the conductor (4), a second Faraday mirror (331), and a delaying element (332) between the second optical fiber winding (330) and the second Faraday mirror (331),
     ◦ the first input branch (30) and the second input branch (31) being coupled to the first sensing branch (32) and to the second sensing branch (33) by means of a splitter (34), and
     ◦ the first optical fiber winding (320) and the second optical fiber winding (330) comprising the same number of turns wound in opposite directions,

   wherein in the method

     i. the first emitter (20) emits a first signal which reaches the first sensing branch (32) through the first input branch (30), travels along the first sensing branch (32) and is modified depending on the current circulating through the conductor (4), and is received by the second receiver (23) from the second input branch (31),
     ii. the second emitter (21) emits a second signal which reaches the first sensing branch (32) through the second input branch (31), travels along the first sensing branch (32) and is modified depending on the current circulating through the conductor (4), and is received by the first receiver (22) from the first input branch (30),
     iii. the first signal also reaches the second sensing branch (33) through the first input branch (30), and the second signal also reaches the second sensing branch (33) through the second input branch (31), the first signal and the second signal travelling along said second sensing branch (33) and being modified depending on the current circulating through the conductor (4),
     iv. the second receiver (23) receives from the second input branch (31) the first signal modified in the second sensing branch (33), the first receiver (22) also receiving from the first input branch (30) the second signal modified in the second sensing branch (33), and
     v. the current circulating through the conductor (4) being determined by combining the first signal modified in the first sensing branch (32) and received by the second receiver (23), the second signal modified in the first sensing branch (32) and received by the first receiver (22), the first signal modified in the second sensing branch (33) and received by the second receiver (23), and the second signal modified in the second sensing branch (33) and received by the first receiver (22).

2. Method according to claim 1, wherein the sensing portion (3) comprises an output branch (35) configured for returning the same signal it receives, the first input branch (30) and the second input branch (31) also being coupled to the output branch (35) by means of a splitter (34), wherein

- the signal emitted by the first emitter (20) reaches the output branch (35) through the first input branch (30), is reflected in said output branch (35), and is received by the first receiver (22) from the first input branch (30) and by the second receiver (23) from the second input branch (31), and
- the signal emitted by the second emitter (21) reaches the output branch (35) through the second input branch (31), is reflected in the conventional mirror (350), and is received by the first receiver (22) from the first input branch (30) and by the second receiver (23) from the second input branch (31),

the signals reflected in the output branch (35) being used to enable continuously adjusting the value of the fiber twist (301).

3. Optical fiber-based measuring equipment for measuring the current circulating through at least one conductor (4), the measuring equipment (1) comprising:

   a. an interrogator (2) comprising a first emitter (20), a second emitter (21), a first receiver (22), and a second receiver (23), and
   b. a sensing portion (3) connected to the interrogator (2) and configured for being arranged in the proximity of the conductor (4), the sensing portion (3) comprising

      - a first input branch (30) comprising a first polarizer (300) and a fiber twist (301) after said first polarizer (300),
      - a second input branch (31) comprising a second polarizer (310),
      - a first sensing branch (32) comprising a first optical fiber winding (320) configured for being arranged in the proximity of the conductor (4) and a first Faraday mirror (321), and
      - a second sensing branch (33) comprising a second optical fiber winding (330) configured for being arranged in the proximity of the conductor (4), a second Faraday mirror (331), and a delaying element (332) between the second optical fiber winding (330) and the second Faraday mirror (331),
      - the first input branch (30) and the second input branch (31) being coupled to the first sensing branch (32) and to the second sensing branch (33) by means of a splitter (34),
      - the first optical fiber winding (320) and the second optical fiber winding (330) comprising the same number of turns that arewound in opposite directions, and

   the measuring equipment (1) being configured to carry out the method according to claim 1.

4. Measuring equipment according to claim 3, comprising an output branch (35) coupled to the first input branch (30) and the second input branch (31) by means of the splitter (34), said output branch (35) being configured for returning the same signal it receives to the splitter (34), the measuring equipment (1) being configured to carry out the method according to claim 2.

5. Measuring equipment according to claim 4, wherein the output branch (35) comprises a conventional mirror (350).

6. Measuring equipment according to claim 4 or 5, wherein the first sensing branch (32) comprises a delaying element between the first optical fiber winding (320) and the first Faraday mirror (321), the delaying element of first the sensing branch (32) and the delaying element (332) of the second sensing branch (33) being different from one another.

7. Measuring equipment according to any of claims 3 to 6, wherein the fiber twist (301) of the first input branch (30) is about 45 degrees.

8. Measuring equipment according to any of claims 3 to 6, wherein the second input branch (31) comprises an additional fiber twist after the second polarizer (310), the sum of the fiber twist (301) of the first input branch (30) and the additional fiber twist of the second input branch (31) preferably being about 45 degrees.


**Patentansprüche**

1. Verfahren zum Messen des durch mindestens einen Leiter (4) zirkulierenden Stroms mit einer glasfaserbasierten Messvorrichtung (1), wobei die Messvorrichtung (1) Folgendes umfasst:

   - einen Interrogator (2), umfassend einen ersten Emitter (20), einen zweiten Emitter (21), einen ersten Empfänger (22) und einen zweiten Empfänger (23), und

- einen Sensorabschnitt (3), der mit dem Interrogator (2) verbunden und ausgebildet ist, um in der Nähe des Leiters (4) angeordnet zu werden, wobei der Sensorabschnitt (3) Folgendes umfasst:

  ◦ einen ersten Eingangszweig (30), umfassend einen ersten Polarisator (300) und einen Faserdrall (301) nach dem ersten Polarisator (300),
  ◦ einen zweiten Eingangszweig (31), umfassend einen zweiten Polarisator (310),
  ◦ einen ersten Sensorzweig (32), umfassend eine erste Glasfaserwicklung (320), die ausgebildet ist, um in der Nähe des Leiters (4) angeordnet zu werden, und einen ersten Faraday-Spiegel (321), und
  ◦ einen zweiten Sensorzweig (33), umfassend eine zweite Glasfaserwicklung (330), die ausgebildet ist, um in der Nähe des Leiters (4) angeordnet zu werden, einen zweiten Faraday-Spiegel (331), und ein Verzögerungselement (332) zwischen der zweiten Glasfaserwicklung (330) und dem zweiten Faraday-Spiegel (331),
  ◦ wobei der erste Eingangszweig (30) und der zweite Eingangszweig (31) mit dem ersten Sensorzweig (32) und dem zweiten Sensorzweig (33) mittels eines Teilers (34) gekoppelt sind, und
  ◦ wobei die erste Glasfaserwicklung (320) und die zweite Glasfaserwicklung (330) die gleiche Anzahl von Windungen umfassen, die in entgegengesetzten Richtungen gewickelt sind,

wobei in dem Verfahren

i. der erste Emitter (20) ein erstes Signal emittiert, das den ersten Sensorzweig (32) über den ersten Eingangszweig (30) erreicht, entlang des ersten Sensorzweigs (32) wandert und in Abhängigkeit von dem durch den Leiter (4) zirkulierenden Strom modifiziert wird und von dem zweiten Empfänger (23) aus dem zweiten Eingangszweig (31) empfangen wird,

ii. der zweite Emitter (21) ein zweites Signal emittiert, das den ersten Sensorzweig (32) über den zweiten Eingangszweig (31) erreicht, entlang des ersten Sensorzweigs (32) wandert und in Abhängigkeit von dem durch den Leiter (4) zirkulierenden Strom modifiziert wird und von dem ersten Empfänger (22) von dem ersten Eingangszweig (30) empfangen wird,

iii. das erste Signal über den ersten Eingangszweig (30) auch den zweiten Sensorzweig (33) erreicht, und das zweite Signal über den zweiten Eingangszweig (31) auch den zweiten Sensorzweig (33) erreicht, wobei das erste Signal und das zweite Signal entlang des zweiten Sensorzweigs (33) wandern und in Abhängigkeit von dem durch den Leiter (4) zirkulierenden Strom modifiziert werden,

iv. der zweite Empfänger (23) von dem zweiten Eingangszweig (31) das in dem zweiten Sensorzweig (33) modifizierte erste Signal empfängt, wobei der erste Empfänger (22) auch von dem ersten Eingangszweig (30) das in dem zweiten Sensorzweig (33) modifizierte zweite Signal empfängt, und

v. der durch den Leiter (4) zirkulierende Strom bestimmt wird, indem das in dem ersten Sensorzweig (32) modifizierte und von dem zweiten Empfänger (23) empfangene erste Signal, das in dem ersten Sensorzweig (32) modifizierte und von dem ersten Empfänger (22) empfangene zweite Signal, das in dem zweiten Sensorzweig (33) modifizierte und von dem zweiten Empfänger (23) empfangene erste Signal und das in dem zweiten Sensorzweig (33) modifizierte und von dem ersten Empfänger (22) empfangene zweite Signal kombiniert werden.

2. Verfahren nach Anspruch 1, wobei der Sensorabschnitt (3) einen Ausgangszweig (35) umfasst, der ausgebildet ist, um das gleiche Signal, das er empfängt, zurückzugeben, wobei der erste Eingangszweig (30) und der zweite Eingangszweig (31) auch mit dem Ausgangszweig (35) mittels eines Teilers (34) gekoppelt sind, wobei

- das von dem ersten Emitter (20) emittierte Signal den Ausgangszweig (35) über den ersten Eingangszweig (30) erreicht, in dem Ausgangszweig (35) reflektiert wird und von dem ersten Empfänger (22) von dem ersten Eingangszweig (30) und von dem zweiten Empfänger (23) von dem zweiten Eingangszweig (31) empfangen wird, und
- das von dem zweiten Emitter (21) emittierte Signal den Ausgangszweig (35) über den zweiten Eingangszweig (31) erreicht, in dem herkömmlichen Spiegel (350) reflektiert wird und von dem ersten Empfänger (22) von dem ersten Eingangszweig (30) und von dem zweiten Empfänger (23) von dem zweiten Eingangszweig (31) empfangen wird,

wobei die im Ausgangszweig (35) reflektierten Signale verwendet werden, um eine kontinuierliche Einstellung des Wertes des Faserdralls (301) zu ermöglichen.

3. Glasfaserbasierte Messvorrichtung zur Messung des durch mindestens einen Leiter (4) zirkulierenden Stroms, wobei die Messvorrichtung (1) Folgendes umfasst:

a. einen Interrogator (2), umfassend einen ersten Emitter (20), einen zweiten Emitter (21), einen ersten Empfänger (22) und einen zweiten Empfänger (23), und

b. einen Sensorabschnitt (3), der mit dem Interrogator (2) verbunden und ausgebildet ist, um in der Nähe des Leiters (4) angeordnet zu werden, wobei der Sensorabschnitt (3) Folgendes umfasst:

- einen ersten Eingangszweig (30), umfassend einen ersten Polarisator (300) und einen Faserdrall (301) nach dem ersten Polarisator (300),
- einen zweiten Eingangszweig (31), umfassend einen zweiten Polarisator (310),
- einen ersten Sensorzweig (32), umfassend eine erste Glasfaserwicklung (320), die ausgebildet ist, um in der Nähe des Leiters (4) angeordnet zu werden, und einen ersten Faraday-Spiegel (321), und
- einen zweiten Sensorzweig (33), umfassend eine zweite Glasfaserwicklung (330), die ausgebildet ist, um in der Nähe des Leiters (4) angeordnet zu werden, einen zweiten Faraday-Spiegel (331), und ein Verzögerungselement (332) zwischen der zweiten Glasfaserwicklung (330) und dem zweiten Faraday-Spiegel (331),
- wobei der erste Eingangszweig (30) und der zweite Eingangszweig (31) mit dem ersten Sensorzweig (32) und dem zweiten Sensorzweig (33) mittels eines Teilers (34) gekoppelt sind,
- wobei die erste Glasfaserwicklung (320) und die zweite Glasfaserwicklung (330) die gleiche Anzahl von Windungen umfassen, die in entgegengesetzten Richtungen gewickelt sind, und

die Messvorrichtung (1) ausgebildet ist, um das Verfahren nach Anspruch 1 durchzuführen.

4. Messvorrichtung nach Anspruch 3, umfassend einen Ausgangszweig (35), der mit dem ersten Eingangszweig (30) und dem zweiten Eingangszweig (31) mittels des Verteilers (34) gekoppelt ist, wobei der Ausgangszweig (35) ausgebildet ist, um das gleiche Signal, das er empfängt, an den Verteiler (34) zurückzugeben, wobei die Messvorrichtung (1) ausgebildet ist, um das Verfahren nach Anspruch 2 durchzuführen.

5. Messvorrichtung nach Anspruch 4, wobei der Ausgangszweig (35) einen herkömmlichen Spiegel (350) umfasst.

6. Messvorrichtung nach Anspruch 4 oder 5, wobei der erste Sensorzweig (32) ein Verzögerungselement zwischen der ersten Glasfaserwicklung (320) und dem ersten Faraday-Spiegel (321) umfasst, wobei sich das Verzögerungselement des ersten Sensorzweigs (32) und das Verzögerungselement (332) des zweiten Sensorzweigs (33) voneinander unterscheiden.

7. Messvorrichtung nach einem der Ansprüche 3 bis 6, wobei der Faserdrall (301) des ersten Eingangszweigs (30) etwa 45 Grad beträgt.

8. Messvorrichtung nach einem der Ansprüche 3 bis 6, wobei der zweite Eingangszweig (31) einen zusätzlichen Faserdrall nach dem zweiten Polarisator (310) umfasst, wobei die Summe aus dem Faserdrall (301) des ersten Eingangszweigs (30) und dem zusätzlichen Faserdrall des zweiten Eingangszweigs (31) vorzugsweise etwa 45 Grad beträgt.

**Revendications**

1. Procédé pour mesurer le courant circulant dans au moins un conducteur (4) avec équipement de mesure à fibre optique (1), l'équipement de mesure (1) comprenant :

- un interrogateur (2) comprenant un premier émetteur (20), un deuxième émetteur (21), un premier récepteur (22) et un deuxième récepteur (23), et
- une partie de détection (3) reliée à l'interrogateur (2) et configurée pour être disposée à proximité du conducteur (4), la partie de détection (3) comprenant :

∘ une première branche d'entrée (30) comprenant un premier polariseur (300) et un tour de fibre (301) après ledit premier polariseur (300),
∘ une deuxième branche d'entrée (31) comprenant un deuxième polariseur (310),

◦ une première branche de détection (32) comprenant un premier enroulement de fibre optique (320) configuré pour être disposé à proximité du conducteur (4) et un premier miroir de Faraday (321), et

◦ une deuxième branche de détection (33) comprenant un deuxième enroulement de fibre optique (330) configuré pour être disposé à proximité du conducteur (4), un deuxième miroir de Faraday (331) et un élément retardateur (332) entre le deuxième enroulement de fibre optique (330) et le deuxième miroir de Faraday (331),

◦ la première branche d'entrée (30) et la deuxième branche d'entrée (31) étant couplées à la première branche de détection (32) et à la deuxième branche de détection (33) par le biais d'un diviseur (34), et

◦ le premier enroulement de fibre optique (320) et le deuxième enroulement de fibre optique (330) comprenant le même nombre de tours enroulés dans des directions opposées,

dans lequel, dans le procédé

i. le premier émetteur (20) émet un premier signal qui atteint la première branche de détection (32) à travers la première branche d'entrée (30), se déplace le long de la première branche de détection (32) et est modifié en fonction du courant circulant dans le conducteur (4), et est reçu par le deuxième récepteur (23) à partir de la deuxième branche d'entrée (31),

ii. le deuxième émetteur (21) émet un deuxième signal qui atteint la première branche de détection (32) à travers la deuxième branche d'entrée (31), se déplace le long de la première branche de détection (32) et est modifié en fonction du courant circulant dans le conducteur (4), et est reçu par le premier récepteur (22) à partir de la première branche d'entrée (30),

iii. le premier signal atteint également la deuxième branche de détection (33) à travers la première branche d'entrée (30), et le deuxième signal atteint également la deuxième branche de détection (33) à travers la deuxième branche d'entrée (31), le premier signal et le deuxième signal se déplaçant le long de ladite deuxième branche de détection (33) et étant modifiés en fonction du courant circulant dans le conducteur (4),

iv. le deuxième récepteur (23) reçoit à partir de la deuxième branche d'entrée (31) le premier signal modifié dans la deuxième branche de détection (33), le premier récepteur (22) recevant également à partir de la première branche d'entrée (30) le deuxième signal modifié dans la deuxième branche de détection (33), et

v. le courant circulant dans le conducteur (4) étant déterminée en combinant le premier signal modifié dans la première branche de détection (32) et reçu par le deuxième récepteur (23), le deuxième signal modifié dans la première branche de détection (32) et reçu par le premier récepteur (22), le premier signal modifié dans la deuxième branche de détection (33) et reçu par le deuxième récepteur (23), et le deuxième signal modifié dans la deuxième branche de détection (33) et reçu par le premier récepteur (22).

2. Procédé selon la revendication 1, dans lequel la partie de détection (3) comprend une branche de sortie (35) configurée pour retourner le même signal qu'elle reçoit, la première branche d'entrée (30) et la deuxième branche d'entrée (31) étant également couplées à la branche de sortie (35) par le biais d'un diviseur (34), dans lequel

- le signal émis par le premier émetteur (20) atteint la branche de sortie (35) à travers la première branche d'entrée (30), est réfléchi dans ladite branche de sortie (35), et est reçu par le premier récepteur (22) à partir de la première branche d'entrée (30) et par le deuxième récepteur (23) à partir de la deuxième branche d'entrée (31), et

- le signal émis par le deuxième émetteur (21) atteint la branche de sortie (35) à travers la deuxième branche d'entrée (31), est réfléchi dans le miroir conventionnel (350), et est reçu par le premier récepteur (22) à partir de la première branche d'entrée (30) et par le deuxième récepteur (23) à partir de la deuxième branche d'entrée (31),

les signaux réfléchis dans la branche de sortie (35) étant utilisés pour permettre d'ajuster en continu la valeur du tour de fibre (301).

3. Équipement de mesure à fibre optique pour mesurer le courant circulant dans au moins un conducteur (4), l'équipement de mesure (1) comprenant :

a. un interrogateur (2) comprenant un premier émetteur (20), un deuxième émetteur (21), un premier récepteur (22) et un deuxième récepteur (23), et

b. une partie de détection (3) reliée à l'interrogateur (2) et configurée pour être disposée à proximité du conducteur (4), la partie de détection (3) comprenant

- une première branche d'entrée (30) comprenant un premier polariseur (300) et un tour de fibre (301) après ledit premier polariseur (300),
- une deuxième branche d'entrée (31) comprenant un deuxième polariseur (310),
- une première branche de détection (32) comprenant un premier enroulement de fibre optique (320) configuré pour être disposé à proximité du conducteur (4) et un premier miroir de Faraday (321), et
- une deuxième branche de détection (33) comprenant un deuxième enroulement de fibre optique (330) configuré pour être disposé à proximité du conducteur (4), un deuxième miroir de Faraday (331) et un élément retardateur (332) entre le deuxième enroulement de fibre optique (330) et le deuxième miroir de Faraday (331),
- la première branche d'entrée (30) et la deuxième branche d'entrée (31) étant couplées à la première branche de détection (32) et à la deuxième branche de détection (33) par le biais d'un diviseur (34),
- le premier enroulement de fibre optique (320) et le deuxième enroulement de fibre optique (330) comprenant le même nombre de tours qui sont enroulés dans des directions opposées, et

l'équipement de mesure (1) étant configuré pour mettre en oeuvre le procédé selon la revendication 1.

4. Équipement de mesure selon la revendication 3, comprenant une branche de sortie (35) couplée à la première branche d'entrée (30) et la deuxième branche d'entrée (31) par le biais du diviseur (34), ladite branche de sortie (35) étant configurée pour retourner le même signal qu'elle reçoit au diviseur (34), l'équipement de mesure (1) étant configuré pour mettre en oeuvre le procédé selon la revendication 2.

5. Équipement de mesure selon la revendication 4, dans lequel la branche de sortie (35) comprend un miroir conventionnel (350).

6. Équipement de mesure selon la revendication 4 ou 5, dans lequel la première branche de détection (32) comprend un élément retardateur entre le premier enroulement de fibre optique (320) et le premier miroir de Faraday (321), l'élément retardateur de la première branche de détection (32) et l'élément retardateur (332) de la deuxième branche de détection (33) étant différents l'un de l'autre.

7. Équipement de mesure selon l'une quelconque des revendications 3 à 6, dans lequel le tour de fibre (301) de la première branche d'entrée (30) est d'environ 45 dégrées.

8. Équipement de mesure selon l'une quelconque des revendications 3 à 6, dans lequel la deuxième branche d'entrée (31) comprend un tour de fibre additionnel après le deuxième polariseur (310), la somme du tour de fibre (301) de la première branche d'entrée (30) et du tour de fibre additionnel de la deuxième branche d'entrée (31) étant de préférence d'environ 45 dégrées.

FIG. 1

FIG. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016198575 A1
- JP H01292263 A
- DE 4227903 C1

- US 20110051145 A1
- US 6297625 B1
- EP 18196585